# EUROPEAN PATENT APPLICATION

(11) **EP 4 632 474 A1**
(43) Date of publication of application: **15.10.2025**
(21) Application number: 23924619.2
(22) Date of filing: 28.02.2023
(51) Int. Cl.: G02F 1/13357

(54) **ARRAY SUBSTRATE, ARRAY MOTHERBOARD, LIGHT-EMITTING SUBSTRATE, BACKLIGHT MODULE, AND DISPLAY DEVICE**

(71) Applicant: Boe Technology Group Co., Ltd., Beijing 100015 (CN); Hefei Boe Ruisheng Technology Co., Ltd., Hefei, Anhui 230012 (CN)
(72) Inventor: LEI, Jie, Beijing 100176 (CN); TIAN, Jian, Beijing 100176 (CN); LIU, Chunjian, Beijing 100176 (CN); ZHANG, Jianying, Beijing 100176 (CN); MA, Yajun, Beijing 100176 (CN)
(74) Representative: Hoffmann Eitle
(86) International application number: PCT/CN2023/078847
(87) International publication number: WO 2024/178647

(57) **Abstract**

An array substrate (10). A relief opening (101) is formed at an edge of the array substrate (10), and the orthographic projection of the relief opening (101) on a first reference plane has a first edge. The array substrate (10) comprises a base substrate (11') and at least one positioning structure (12). The at least one positioning structure (12) is arranged on one side of the base substrate (11'). The positioning structure (12) comprises a body portion (124), and the body portion (124) is substantially parallel with the first edge. The first reference plane is a plane where the surface of the base substrate away from the positioning structure (12) is located.

## Description

### TECHNICAL FIELD

The present disclosure relates to the field of display technologies, and in particular, to an array substrate, an array motherboard, a light-emitting substrate, a backlight module, and a display apparatus.

### BACKGROUND

With the development of light-emitting diode (LED) technology, backlight sources utilizing LEDs with sub-millimeter (Micro) or even micron (Mini) scale have been widely used. As a result, not only can the contrast ratio of products utilizing these backlight sources, e.g., a liquid crystal display (LCD), reach the level of organic light-emitting diode (OLED) display products, but it can also enable the products to retain the technical advantages of LCD, thereby enhancing the display effect of images and providing users with a high-quality visual experience.

### SUMMARY

In an aspect, an array substrate is provided. The array substrate is provided with an avoidance notch at an edging of the array substrate, an orthographic projection of the avoidance notch on a first reference plane having a first edge. The array substrate includes a substrate and at least one positioning structure. The at least one positioning structure is provided on a side of the substrate. A positioning structure includes a main portion, the main portion being substantially parallel to the first edge. The first reference plane is a plane where a surface, away from the positioning structure, of the substrate is located.

In some embodiments, the first edge of the orthographic projection of the avoidance notch on the first reference plane is in an arc-shape, and an orthographic projection of the positioning structure on the first reference plane is in an arc-shape.

In some embodiments, the positioning structure further includes end portions located at both ends of the main portion, and the end portions of the positioning structure are substantially parallel to a corresponding boundary of the array substrate.

In some embodiments, the main portion of the positioning structure surrounds the avoidance notch, and the avoidance notch is located between the two end portions of the positioning structure.

In some embodiments, the array substrate further includes a first conductive metal layer, a first insulating layer, and a second conductive metal layer. The first conductive metal layer is provided on a side of the substrate, and the first conductive metal layer includes a plurality of signal lines. The first insulating layer is provided on a side of the first conductive metal layer away from the substrate, and the first insulating layer is provided with first via holes penetrating the first insulating layer. The second conductive metal layer is provided on a side of the first insulating layer away from the substrate, and the second conductive metal layer includes a plurality of conductive portions and a plurality of transfer lines, where a transfer line is connected to a conductive portion and is in electrical contact with a signal line through a first via hole. The positioning structure is located in any one of the first conductive metal layer, the second conductive metal layer and the first insulating layer.

In some embodiments, the first insulating layer includes a first insulating sub-layer and a second insulating sub-layer that are provided in a stack, the first insulating sub-layer being closer to the first conductive metal layer relative to the second insulating sub-layer.

In some embodiments, the array substrate further includes a second insulating layer. The second insulating layer is provided on a side of the second conductive metal layer away from the substrate, and the second insulating layer is provided with second via holes penetrating the second insulating layer, where a second via hole exposes at least a partial region of the conductive portion. The positioning structure is located in any one of the first conductive metal layer, the second conductive metal layer, the first insulating layer, and the second insulating layer.

In some embodiments, the array substrate further includes an alignment mark layer. The alignment mark layer is provided between the first conductive metal layer and the substrate, and the alignment mark layer includes at least one alignment mark. The positioning structure is located in any one of the first conductive metal layer, the second conductive metal layer, the first insulating layer, and the alignment mark layer; in a case where the array substrate includes a second insulating layer, the positioning structure is located in any one of the first conductive metal layer, the second conductive metal layer, the first insulating layer, the second insulating layer, and the alignment mark layer.

In some embodiments, a side, proximate to the avoidance notch, of the main portion of the positioning structure is exposed by the avoidance notch, and the positioning structure is located in the first insulating layer; in a case where the array substrate includes a second insulating layer, the positioning structure is located in the first insulating layer or the second insulating layer.

In some embodiments, the array substrate includes a plurality of positioning structures, the plurality of positioning structures being of a same material and provided in a same layer.

In another aspect, an array motherboard is provided. The array motherboard includes a plurality of array sub-boards, the array sub-boards each including a light-emitting region and a test region, where the test region is located on at least one side of the light-emitting region, the test region includes a functional device arrangement region and a peripheral region, and a border between the peripheral region and the functional device arrangement region is a first demarcation line.

The array sub-board includes a substrate motherboard and at least one positioning structure. The at least one positioning structure is provided on the substrate motherboard and located in the test region, a positioning structure including a main portion, and the main portion being substantially parallel to the first demarcation line. There exists at least such a positioning structure, at least a part of a main portion of the positioning structure is located in the array region; a boundary, located in the peripheral region, of the main portion of the positioning structure has a maximum distance with the first demarcation line, and the maximum distance is greater than a first preset value and less than or equal to a second preset value, where the first preset value is a process accuracy at which a portion, located in the functional device arrangement region, of the array sub-board is capable of being removed, and the second preset value is a minimum distance between the light-emitting region and the first demarcation line.

In some embodiments, the first demarcation line is in an arc-shape, the positioning structure further includes end portions located at both ends of the main portion, and the end portions of the positioning structure are substantially parallel to a corresponding boundary of the array sub-board.

In some embodiments, a positioning structure with a main portion located in the peripheral region is a first positioning structure; a positioning structure with a main portion located in the functional device arrangement region is a second positioning structure; and a positioning structure with a part of a main portion located in the peripheral region and another part of the main portion located in the functional device arrangement region is a third positioning structure.

The main portion of the first positioning structure surrounds the first demarcation line, and the first demarcation line is located between two end portions of the first positioning structure. The first demarcation line surrounds the main portion of the second positioning structure, and the first demarcation line is located between two end portions of the second positioning structure. The main portion of the third positioning structure covers the first demarcation line, and the first demarcation line is located between two end portions of the third positioning structure.

In some embodiments, the array sub-board includes a plurality of positioning structures, and the end portions of the positioning structure are substantially parallel to a corresponding boundary of the array sub-board. Among the plurality of positioning structures, both ends of a positioning structure furthest from a center of the array substrate extend to a boundary of the array sub-board, and end portions of the positioning structure are substantially flush with the boundary of the array sub-board; and/or same ends of the plurality of positioning structures are connected to form a first line segment, and a line where the first line segment is in intersects with and is substantially perpendicular to a boundary of the peripheral region.

In some embodiments, the array sub-board includes a plurality of positioning structures; and among the plurality of positioning structures, there exists at least such a positioning structure whose main portion has an orthographic projection on a second reference plane substantially overlapping with an orthogonal projection of the first demarcation line on the second reference plane, and the second reference plane is a plane where a surface, away from the positioning structures, of the substrate motherboard is located.

In some embodiments, the array motherboard further includes a first metal film, a first insulating film, a second metal film, and a second insulating film. The first metal film is provided on a side of the substrate motherboard, and the first metal film includes a plurality of signal lines. The first insulating film is provided on a side of the first metal film away from the substrate motherboard, and the first insulating film is provided with first via holes penetrating the first insulating film.

The second metal film is provided on a side of the first insulating film away from the substrate motherboard, and the second metal film includes a plurality of conductive portions and a plurality of transfer lines, where a transfer line is connected to a conductive portion and is in electrical contact with a signal line through a first via hole. The second insulating film is provided on a side of the second metal film away from the substrate motherboard, and the second insulating film is provided with second via holes penetrating the second insulating film, where a second via hole exposes at least a partial region of the conductive portion. The positioning structure is located in any one of the first metal film, the second metal film, the first insulating film, and the second insulating film.

In some embodiments, a positioning structure with a main portion located in the peripheral region is a first positioning structure; a positioning structure with a main portion located in the functional device arrangement region is a second positioning structure; and a positioning structure with a part of a main portion located in the peripheral region and another part of the main portion located in the functional device arrangement region is a third positioning structure. The first positioning structure is located in any one of the first metal film, the second metal film, the first insulating film, and the second insulating film. The second positioning structure is located in the first insulating film or the second insulating film; and the third positioning structure is located in the first insulating film or the second insulating film.

In yet another aspect, a light-emitting substrate is provided. The light-emitting substrate includes the array substrate described in any of the above embodiments, and a plurality of electronic devices that are provided on the array substrate.

In still another aspect, a backlight module is provided. The backlight module includes the light-emitting substrate described in any of the above embodiments and a plurality of optical film sheets. The light-emitting substrate has a light-exit side and a non-light-exit side opposite to each other. The plurality of optical film sheets are provided on the light-exit side of the light-emitting substrate.

In still yet another aspect, a display apparatus is provided. The display apparatus includes the backlight module described in any of the above embodiments, a functional device, and a display panel. The functional device is provided at the avoidance notch of the array substrate in the backlight module. The display panel is provided on a side, away from the light-emitting substrate, of the plurality of optical film sheets in the backlight module.

### BRIEF DESCRIPTION OF THE DRAWINGS

In order to describe technical solutions in the present disclosure more clearly, the accompanying drawings to be used in some embodiments of the present disclosure will be introduced briefly; however, the accompanying drawings to be described below are merely drawings of some embodiments of the present disclosure, and a person of ordinary skill in the art can obtain other drawings according to those drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a structural diagram of a display apparatus, in accordance with some embodiments;
FIG. 2 is a structural diagram of another display apparatus, in accordance with some embodiments;
FIG. 3 is a structural diagram of yet another display apparatus, in accordance with some embodiments;
FIG. 4 is a sectional view of a display apparatus, in accordance with some embodiments;
FIG. 5 is a circuit diagram of a light-emitting substrate, in accordance with some embodiments;
FIG. 6 is a top view of a light-emitting substrate, in accordance with some embodiments;
FIG. 7 is a top view of a partial layout of a light-emitting substrate, in accordance with some embodiments;
FIG. 8 is a structural diagram of an array substrate, in accordance with some embodiments;
FIG. 9 is a structural diagram of another array substrate, in accordance with some embodiments;
FIG. 10 is a structural diagram of yet another array substrate, in accordance with some embodiments;
FIG. 11A is a partially enlarged view of an array substrate at an avoidance notch, in accordance with some embodiments;
FIG. 11B is a sectional view taken along the section line A-A' in FIG. 11A;
FIG. 11C is another sectional view taken along the section line A-A' in FIG. 11 A;
FIG. 11D is yet another sectional view taken along the section line A-A' in FIG. 11A;
FIG. 12 is a partially enlarged view of another array substrate at an avoidance notch, in accordance with some embodiments;
FIG. 13A is a partially enlarged view of yet another array substrate at an avoidance notch, in accordance with some embodiments;
FIG. 13B is a sectional view taken along the section line B-B' in FIG. 13A;
FIG. 14 is a sectional view of an array substrate, in accordance with some embodiments;
FIG. 15 is a structural diagram of an array motherboard, in accordance with some embodiments;
FIG. 16A is a structural diagram of an array sub-board, in accordance with some embodiments;
FIG. 16B is a sectional view taken along the section line C-C' in FIG. 16A;
FIG. 17 is a structural diagram of another array sub-board, in accordance with some embodiments;
FIG. 18 is a partially enlarged view of a functional device placement region of an array substrate, in accordance with some embodiments;
FIG. 19 is a partially enlarged view of a functional device placement region of another array substrate, in accordance with some embodiments;
FIG. 20 is a partially enlarged view of a functional device placement region of yet another array substrate, in accordance with some embodiments;
FIG. 21 is a partially enlarged view of the region M in FIG. 20; and
FIG. 22 is a sectional view of an array motherboard, in accordance with some embodiments.

### DETAILED DESCRIPTION

The technical solutions in some embodiments of the present disclosure will be described clearly and completely with reference to the accompanying drawings; however, the described embodiments are merely some but not all embodiments of the present disclosure. All other embodiments obtained by a person of ordinary skill in the art based on embodiments of the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to." In the description of the specification, the terms such as "one embodiment," "some embodiments," "exemplary embodiments," "example," "specific example," or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics may be included in any one or more embodiments or examples in any suitable manner.

The terms "first" and "second" are used for descriptive purposes only, and are not to be construed as indicating or implying a relative importance or implicitly indicating a number of indicated technical features. Thus, features defined with "first" or "second" may explicitly or implicitly include one or more of the features. In the description of the embodiments of the present disclosure, the term "a plurality of" or "multiple" means two or more unless otherwise specified.

In the description of some embodiments, the expressions "coupled," "connected," and derivatives thereof may be used. The term "connected" should be understood in a broad sense. For example, the term "connected" may represent a fixed connection, a detachable connection, or a one-piece connection, or may represent a direct connection, or may represent an indirect connection through an intermediate medium. The term "coupled" indicates that two or more components are in direct physical or electrical contact with each other. The term "coupled" or "communicatively coupled" may also mean that two or more components are not in direct contact with each other but still cooperate or interact with each other. The embodiments disclosed herein are not necessarily limited to the content herein.

The phrase "at least one of A, B, and C" has the same meaning as the phrase "at least one of A, B, or C", both including the following combinations of A, B, and C: only A, only B, only C, a combination of A and B, a combination of A and C, a combination of B and C, and a combination of A, B, and C.

The phrase "A and/or B" includes the following three combinations: only A, only B, and a combination of A and B.

The use of the phrase "applicable to" or "configured to" herein means an open and inclusive expression, which does not exclude devices that are applicable to or configured to perform additional tasks or steps.

In addition, the use of the phrase "based on" or "according to" is meant to be open and inclusive, since a process, step, calculation, or other actions that are "based on" or "according to" one or more of the stated conditions or values may, in practice, be based on or according to additional conditions or values exceeding those stated.

The term such as "about," "substantially," or "approximately" as used herein includes a stated value and an average value within an acceptable range of deviation of a particular value. The acceptable range of deviation is determined by a person of ordinary skill in the art, considering measurement in question and errors associated with measurement of a particular quantity (i.e., limitations of a measurement system).

The term such as "parallel," "perpendicular," or "equal" as used herein includes a stated condition and a condition similar to the stated condition. A range of the similar condition is within an acceptable deviation range, and the acceptable deviation range is determined by a person of ordinary skill in the art, considering measurement in question and errors associated with measurement of a particular quantity (i.e., the limitations of a measurement system). For example, the term "equal" includes absolute equality and approximate equality, and an acceptable range of deviation of the approximate equality may be a difference between two equals being less than or equal to 5% of either of the two equals.

It will be understood that when a layer or element is referred to as being on another layer or substrate, the layer or element may be directly on the another layer or substrate, or there may be intermediate layer(s) between the layer or element and the another layer or substrate.

Exemplary embodiments are described herein with reference to sectional views and/or plan views that are schematic illustrations of idealized embodiments. In the accompanying drawings, thicknesses of layers and areas of regions are enlarged for clarity. Thus, variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a curved feature. Therefore, the regions shown in the accompanying drawings are schematic in nature, and their shapes are not intended to show actual shapes of the regions in a device, and are not intended to limit the scope of the exemplary embodiments.

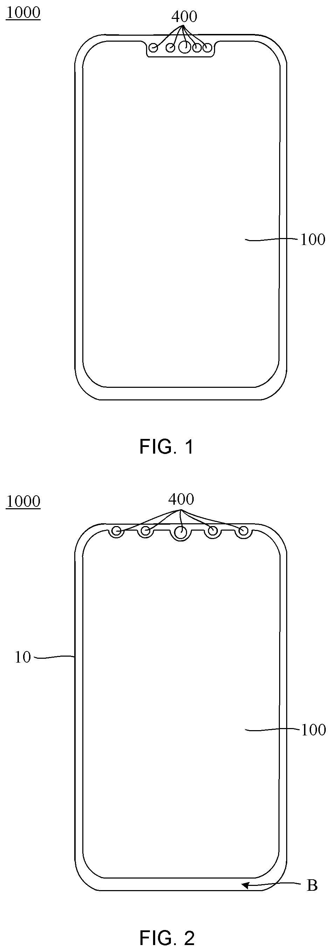

As shown in FIG. 1, some embodiments of the present disclosure provide a display apparatus 1000. The display apparatus 1000 may be any apparatus that can display an image whether in motion (e.g., video) or stationary (e.g., still image) and whether text or pictorial.

Exemplarily, referring to FIGS. 1, 2, and 3, the display apparatus 1000 may be any product or component having a display function, such as a television, a laptop computer, a tablet computer, a mobile phone, a personal digital assistant (PDA), a navigator, a wearable device, or a virtual reality (VR) device.

The above-described display apparatus 1000 may be a liquid crystal display (LCD) apparatus or a miniature light-emitting display apparatus (Mini/Micro Light-Emitting Display), and the embodiments of the present disclosure are not specifically limited herein.

The following takes the above-mentioned display apparatus 1000 as an LCD apparatus as an example to schematically illustrate some embodiments of the present disclosure. However, the implementations of the present disclosure are not limited thereto, and any other display apparatus 1000 may also be considered, as long as the same technical ideas are applied.

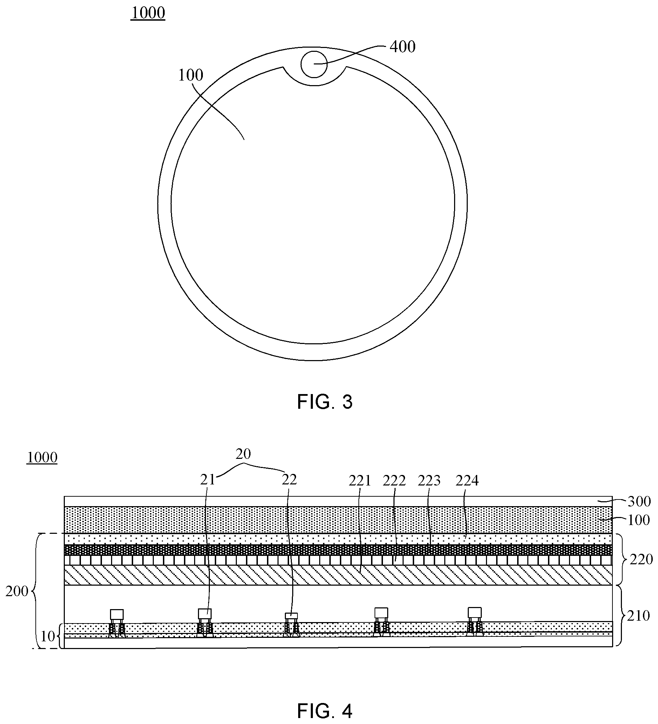

In some embodiments, referring to FIG. 4, the display apparatus 1000 includes a display panel 100.

As shown in FIG. 4, the display panel 100 includes a light-exit side and a non-light-exit side arranged oppositely. The light-exit side refers to a side of the display panel 100 on which images are displayed (the upper side of the display panel 100 in FIG. 4), and the non-light-exit side is the other side opposite the light-exit side (the lower side of the display panel 100 in FIG. 4).

It can be understood that a shape of a surface at the light-exit side of the display panel 100 is not unique depending on different application scenarios.

For example, as shown in FIGS. 1 and 2, the display apparatus 1000 may be a portable display product, which may be a mobile phone as shown in FIGS. 1 and 2. In this case, a surface at the light-exit side of the display panel 100 is substantially in a shape of a rectangle.

As used herein, the "substantially in a shape of a rectangle" means that an object described is in a shape of a rectangle as a whole, but is not limited to a standard rectangle. That is, "rectangle" herein includes not only the shape of a basic rectangle, but also a shape similar to a rectangle. For example, the long and short sides of the rectangle are curved at each intersecting position (i.e., a corner), that is, the corners are smooth, so that the shape is a rounded rectangle. For example, some of segments on the long and short sides of the rectangle are curved.

As another example, as shown in FIG. 3, the display apparatus 1000 may be a wearable device, which may be a circular watch as shown in FIG. 3. In this case, a surface at the light-exit side of the display panel 100 is substantially in a shape of a circle or ellipse.

As used herein, the "substantially in a shape of a circle or ellipse" means that an object described is in a shape of a circle or ellipse as a whole, but is not limited to a standard circle or ellipse. That is, "circle or ellipse" herein includes not only the shape of a basic circle or ellipse, but also a shape similar to a circle or ellipse.

Taking the above-mentioned display apparatus 1000 as a bar mobile phone in which the surface at the light-exit side of the display panel 100 is substantially in the shape of a rectangle, some embodiments of the present disclosure are schematically described below, but the embodiments of the present disclosure are not limited thereto.

Exemplarily, referring to FIGS. 1 to 4, the display apparatus 1000 further includes a backlight module 200, a glass cover 300, and functional device(s) 400.

As shown in FIGS. 1 to 3, the functional device(s) 400 include at least one of an image sensor, an optical sensor, an acoustic sensor, a distance sensor, or the like. For example, the functional device(s) 400 include at least one of a camera, a speaker, a flash, an infrared sensor, a proximity sensor, an eye-tracking module, a face recognition module, or the like.

Some embodiments of the present disclosure are illustrated schematically below using a functional device 400 described above as an example of a camera, but the embodiments of the present disclosure are not limited thereto and any other functional device 400 may also be contemplated as well, as long as the same technical ideas are applied.

As shown in FIG. 4, the backlight module 200 is provided on a non-light-exit side of the display panel 100, and the backlight module 200 is used to provide a light source for the display panel 100.

As shown in FIG. 4, the glass cover 300 is provided on the light-exit side of the display panel 100, and the glass cover 300 is used to protect the display panel 100. Exemplarily, a material used for the glass cover 300 may be selected from a rigid material such as glass, quartz or plastic, or may be selected from a flexible material such as polymer resin.

In some examples, continuing to refer to FIG. 4, the backlight module 200 includes a light-emitting substrate 210 and a plurality of optical film sheets 220.

As shown in FIG. 4, the light-emitting substrate 210 has a light-emitting side and a non-light-emitting side opposite thereto, in which the light-emitting side refers to a side of the light-emitting substrate 210 that provides the light source (the upper side of the light-emitting substrate 210 in FIG. 4), and the non-light-emitting side refers to the other side opposite the light-emitting side (the lower side of the light-emitting substrate 210 in FIG. 4).

It would be appreciated that the shape of a surface at the light-emitting side of the light-emitting substrate 210 should be substantially the same as the shape of a surface at the light-exit side of the display panel 100. That is, in a case where the surface at the light-exit side of the display panel 100 is substantially in a shape of a circle or ellipse, the surface at the light-emitting side of the light-emitting substrate 210 is also substantially in the shape of the circle or ellipse; and in a case where the surface at the light-exit side of the display panel 100 is substantially in a shape of a rectangle, the surface at the light-emitting side of the light-emitting substrate 210 is also substantially in the shape of the rectangle.

As shown in FIG. 4, the plurality of optical film sheets 220 are provided on the light-exit side of the light-emitting substrate 210.

Here, the light-emitting substrate 210 can directly emit white light rays, and the white light rays are directed to the display panel 100 after undergoing a uniformity process via the plurality of optical film sheets 220. Alternatively, the light-emitting substrate 210 can emit other colors of light (e.g., blue light), and the light is directed to the display panel 100 after undergoing color conversion and uniformity processes via the plurality of optical film sheets 220.

Exemplarily, referring to FIG. 4, the plurality of optical film sheets 220 include a diffusion plate 221, a quantum dot film 222, a diffusion sheet 223, and a composite film 224 which are provided in sequence along a direction perpendicular to the light-emitting substrate 210 and away from the light-emitting substrate 210.

Among these film sheets, the diffusion plate 221 is capable of diffusing light rays emitted from the light-emitting substrate 210 and providing support for the quantum dot film 222, the diffusion sheet 223, and the composite film 224; excited by a certain color of light rays emitted from the light-emitting substrate 210, the quantum dot film 222 is capable of converting these light rays into white light rays to increase the utilization of the light energy of the light-emitting substrate 210; the diffusion sheet 223 is capable of uniforming the light rays passing therethrough; and the composite film 224 is capable of enhancing the light-output efficiency of the backlight module 200 to improve the display brightness of the display apparatus 1000.

It will be noted that the composite film 224 may include a brightness enhancement film (BEF) and a reflective polarizing brightness enhancement film (dual brightness enhancement film, DBEF for short), which utilizes the principles of total reflection, refraction, and polarization to increase the flux of light rays in a certain angle range, thereby improving the brightness of the display device 1000.

For example, the light-emitting substrate 210 emits blue light rays in a direction away from the light-emitting substrate 210. The quantum dot film 222 may contain a red quantum dot material, a green quantum dot material and a transparent material. Blue light rays emitted by the light-emitting substrate 210 are converted to red light rays after passing through the red quantum dot material; blue light rays are converted to green light rays after passing through the green quantum dot material; and blue light rays may pass directly through the transparent material; and then, the blue light rays, the red light rays and the green light rays are presented as white light after being mixed and superimposed in a certain ratio. The diffusion plate 221 and the diffusion sheet 223 are capable of mixing the white light to improve the light shadow produced by the light-emitting substrate 210, thereby improving the image quality displayed on the display apparatus 1000.

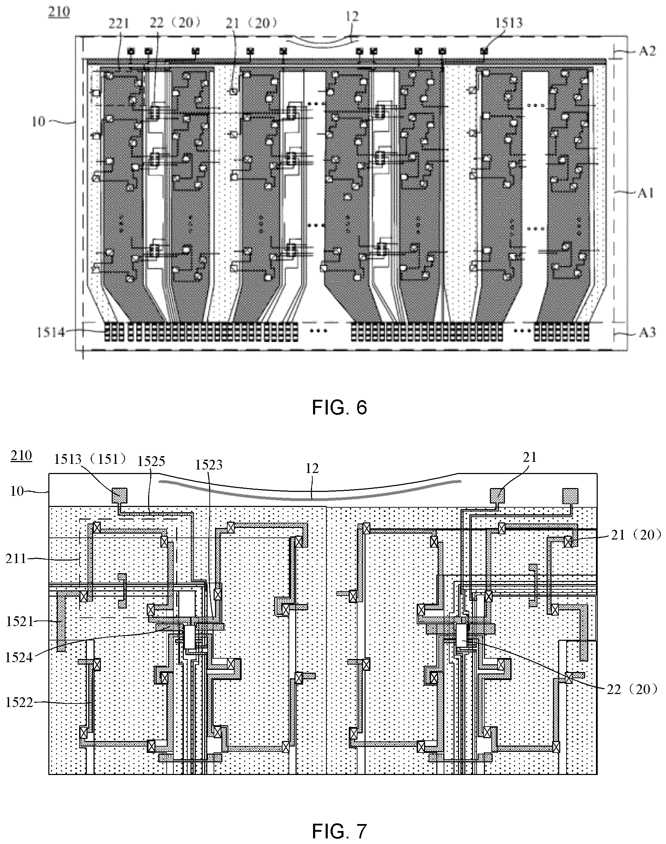

In some embodiments, referring to FIG. 6, the light-emitting substrate 210 has a light-emitting region A1 and a test region A2 located on at least one side of the light-emitting region A1.

Exemplarily, as shown in FIG. 6, the light-emitting substrate 210 further has a bonding region A3, and the test region A2 and the bonding region A3 are located on opposite sides of the light-emitting region A1, respectively.

Here, the light-emitting substrate 210 includes an array substrate 10 and electronic components 20, where the electronic components 20 are provided on the array substrate 10 and located in the light-emitting region A1.

Exemplarily, referring to FIG. 4, the electronic components 20 may be electrically connected to pads on the array substrate 10 to be fixed to the array substrate 10.

Herein, referring to FIG. 4, the electronic components 20 above-described may include light-emitting devices 21 and/or microchips 22.

As shown in FIG. 4, the light-emitting devices 21 may include Micro LEDs and Mini LEDs. The Micro LEDs have a size (e.g., length) of less than 50 µm, e.g., from 10 µm to 50 µm, inclusive; and the Mini LEDs have a size (e.g., length) of 50 µm to 150 µm, inclusive, e.g., of 80 µm to 120 µm, inclusive.

As shown in FIG. 4, the microchips 22 may include sensing chips and driving chips. The sensing chip may be, for example, a photosensitive sensor chip or a thermal sensor chip. The driving chip is used to provide a driving signal to a light-emitting device 21.

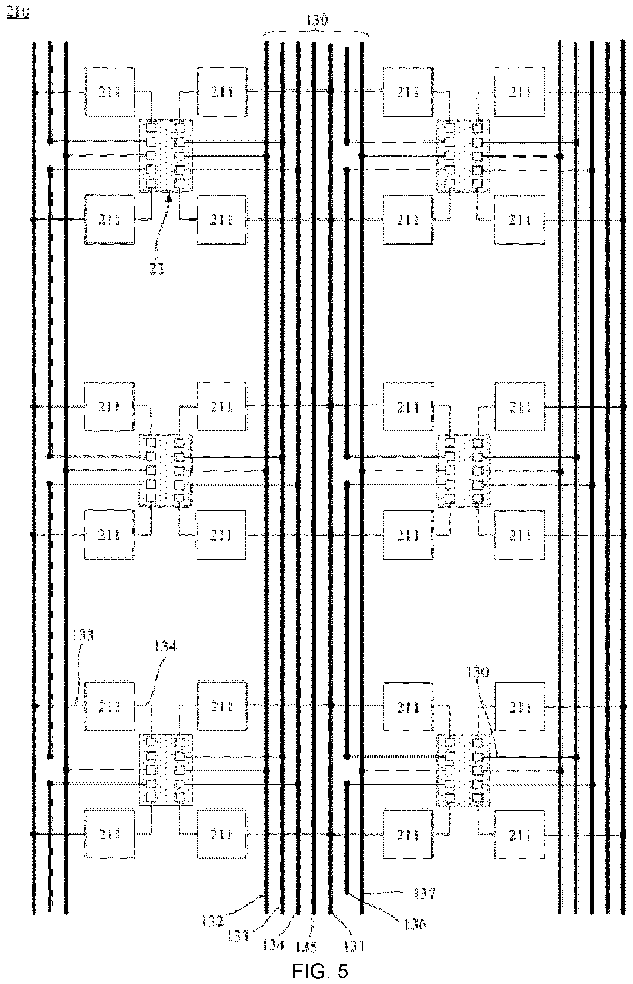

As shown in FIGS. 5, 6, and 7, the light-emitting substrate 210 includes a plurality of driving units 211 arranged in an array, each driving unit 211 including multiple light-emitting devices 21 connected in series and/or in parallel.

Exemplarily, as shown in FIGS. 5, 6, and 7, each driving unit 211 includes 4 light-emitting devices 21 connected in series in sequence. Of course, each driving unit 211 may also include 4, 5, 7, or 8 light-emitting devices 21, and a connection of multiple light-emitting devices 21 in the driving unit 211 is not limited to a series connection, but may also be a parallel connection, which are not limited to embodiments of the present disclosure.

The microchip 22 described above may, for example, be a driving chip to drive multiple light-emitting devices 21 to emit light. Here, one microchip 22 may drive multiple light-emitting devices 21 in a respective single driving unit 211; alternatively, one microchip 22 may drive multiple light-emitting devices 21 in multiple driving units 211 separately.

Exemplarily, as shown in FIGS. 5 and 6, every 4 driving units 211 are electrically connected to one microchip 22, and this one microchip 22 is electrically connected to multiple light-emitting devices 21 in the 4 driving units 211 separately, so as to separately drive the multiple light-emitting devices 21 in the 4 driving units 211 to emit light.

As shown in FIGS. 1 to 3, the above-described functional device 400 may be provided in the middle of the upper end of the array substrate 10. As shown in FIG. 2, the functional device 400 may also be provided at a corner of the upper end of the array substrate 10 to the left or to the right. Of course, the functional device 400 may also be provided at other positions of the array substrate 10, and the embodiments of the present disclosure are not specifically limited herein.

In the related art, there exists an interference between the functional device and the array substrate during system assembly, so the functional device and the array substrate push against each other, resulting in deformation of the array substrate or failure of the functional device. In light of this, how to avoid the interference between the array substrate and the functional device is a current problem to be solved.

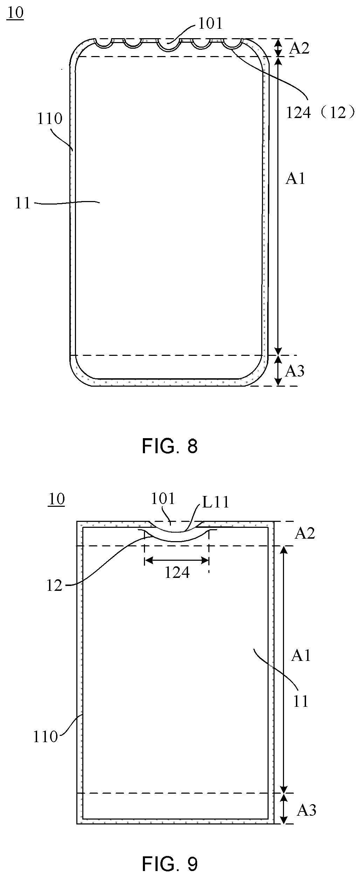

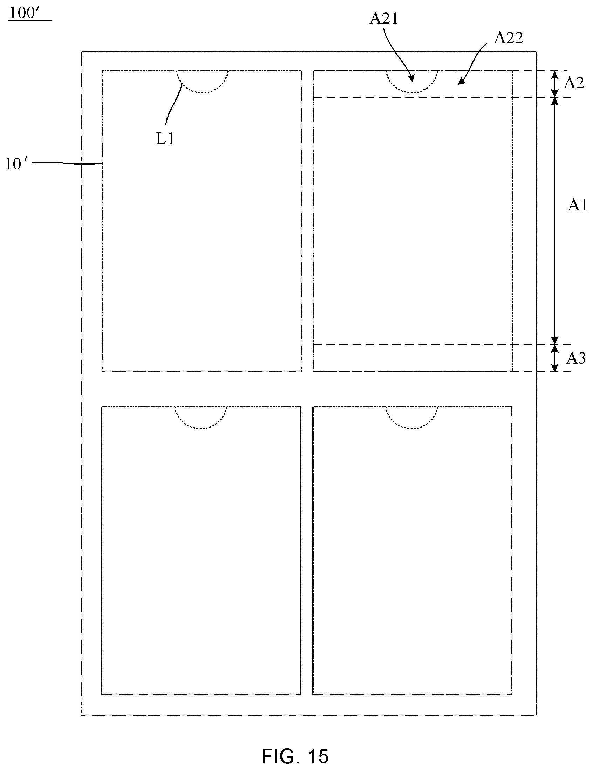

In order to reduce manufacturing costs, referring to FIG. 15, the array substrate 10 (refer to FIG. 9) is typically obtained from an array motherboard 100' by processes such as cutting. Some embodiments of the present disclosure provide an array motherboard 100' including a plurality of array sub-boards 10'. The array sub-board 10' includes a light-emitting region A1 and a test region A2, where the test region A2 includes a functional device arrangement region A21 and a peripheral region A22.

Referring to FIGS. 9 and 15, a portion of the array sub-board 10' located in the peripheral region A22 is a portion of the array sub-board 10' retained to form a required array substrate 10.

Referring to FIGS. 9 and 15, a portion of the array sub-board 10' located in the functional device arrangement region A22 is a portion of the array sub-board 10' that is required to be removed to form an avoidance notch 101 to avoid the interference between the functional device 400 and the array substrate 10, so as to avoid the pushing between the functional device 400 (refer to FIG. 2) and the array substrate 10, thereby reducing the risk that the array substrate 10 produces a deformation or risk of failure of the functional device.

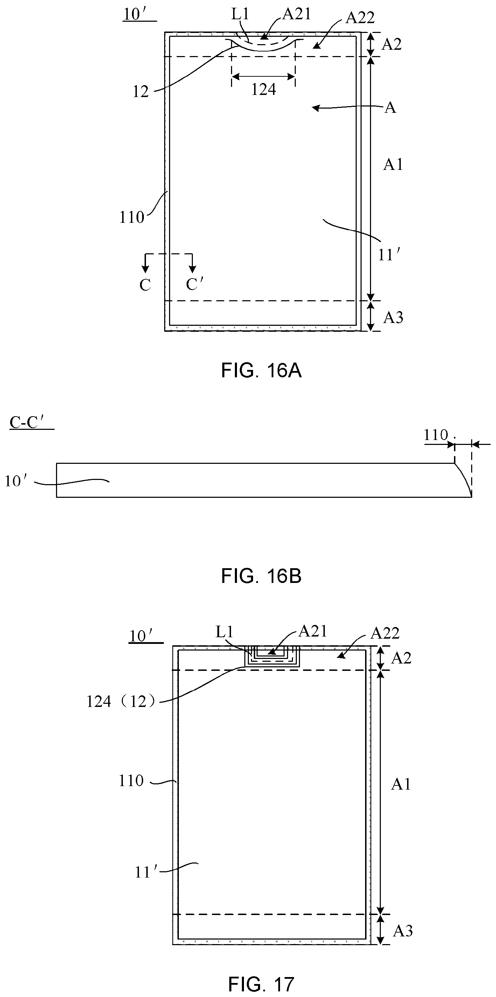

Referring to FIG. 16A, the functional device arrangement region A21 is located at the edging of the peripheral region A22, and the peripheral region A22 and the functional device arrangement region A21 have a border between therebetween, which is a first demarcation line L1.

The shape of the above functional device arrangement region A21 can be set according to the shape and position of the functional device 400.

Exemplarily, referring to FIGS. 16A and 17, the first demarcation line L1 is substantially in any one of a right-angled U-shape (" 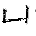 "-shape), a U-shape, and an arc-shape.

For example, as shown in FIG. 16A, the first demarcation line L1 is substantially in an arc-shape. As another example, as shown in FIG. 17, the first demarcation line L1 is substantially in a right-angled U-shape (" 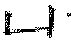 "-shape).

As used herein, "substantially in an arc-shape" means that the shape of a described object is in an arc-shape as a whole, but is not limited to a standard arc-shape. That is, "arc" herein includes not only standard arc-shapes, but also arc-like shapes.

Some embodiments of the present disclosure are schematically illustrated below using the first demarcation line L1 being substantially in an arc-shape as an example, but the embodiments of the present disclosure are not limited thereto.

The area of the above-described functional device arrangement region A21 may be set according to the area and shape of the functional device 400.

In some examples, a distance between both ends of the first demarcation line L1 is in a range of 15 mm to 25 mm, inclusive. For example, the distance between both ends of the first demarcation line L1 is any one of 15 mm, 16 mm, 16.5 mm, 17 mm, 18 mm, 18.7 mm, 19 mm, 19.5 mm, 20 mm, 20.1 mm, 20.5 mm, 21 mm, 21.3 mm, 22 mm, 22.5 mm, 23 mm, 23.5 mm, 24 mm, 24.5 mm, and 25 mm, and embodiments of the present disclosure are not specifically limited herein.

In some examples, the distance between both ends of the first demarcation line L1 is in a range of 60 mm to 70 mm, inclusive. For example, the distance between both ends of the first demarcation line L1 is any one of 60 mm, 60.5 mm, 61 mm, 62.1 mm, 63.5 mm, 64 mm, 64.3 mm, and 65 mm, and embodiments of the present disclosure are not specifically limited herein.

In some examples, a portion, corresponding to the functional device arrangement region A21, of a boundary of the array sub-board 10' has a maximum distance from the first demarcation line L1 in a range of 1 mm to 2 mm, inclusive. For example, the maximum distance between the portion, corresponding to the functional device arrangement region A21, of the boundary of the array sub-board 10' and the first demarcation line L1 is any one of 1 mm, 1.1 mm, 1.2 mm, 1.3 mm, 1.35 mm, 1.355 mm, 1.4 mm, 1.45 mm, 1.5 mm, 1.6 mm, 1.7 mm, 1.8 mm, 1.9 mm, and 2 mm, and the embodiments of the present disclosure are not specifically limited herein.

Here, the array motherboard 100' can be preliminarily divided by a cutting process to obtain a plurality of array sub-boards 10', and then a functional device arrangement region A21 of an array sub-board 10' can be removed to obtain an array substrate 10 having an avoidance notch 101.

For example, referring to FIGS. 15, 16A, 16B, and 17, a grinding tool may be utilized to remove a portion of the array sub-board 10' that is located in the functional device arrangement region A21 by a grinding process, and prior to this step, an edging of the array sub-board 10' may be ground to form a chamfered structure 110, which may increase the strength of the array sub-board 10', and avoid cracks during removal of the functional device arrangement region A21 of the array sub-board 10'.

On a second reference plane, a distance between orthographic projections of two opposite boundaries of the above chamfered structure 110 may be in a range of, for example, 250 µm to 350 µm. Exemplarily, on the second reference plane, the distance between the orthographic projections of the two opposite boundaries of the chamfered structure 110 is any one of 250 µm, 260 µm, 270 µm, 280 µm, 290 µm, 300 µm, 310 µm, 320 µm, 330 µm, 340 µm, and 350 µm, and embodiments of the present disclosure are not specifically limited herein.

It will be noted that the second reference plane is a plane where a surface, away from the display panel 100, of the array motherboard 100' is located.

In some embodiments, referring to FIGS. 16A and 17, the array sub-board 10' includes a substrate motherboard 11' and at least one positioning structure 12.

As shown in FIGS. 16A and 17, the substrate motherboard 11' may employ any one of substrates including, for example, a glass substrate, a quartz substrate, a sapphire substrate, and a ceramic substrate, or employ any one of a semiconductor substrate such as a single-crystal semiconductor substrate or polycrystalline semiconductor substrate made of materials of silicon or silicon carbide, a compound-semiconductor substrate based on silicon-germanium, and a silicon-on-insulator (SOI) substrate. The substrate motherboard 11' may also employ a film layer made of one or more organic resin materials such as epoxy, triazine, silicone, and polyimide.

As shown in FIGS. 16A and 17, the positioning structure 12 is provided on the substrate motherboard 11' and located in the test region A2; and the positioning structure 12 includes a main portion 124, where the main portion 124 is substantially parallel to the first demarcation line L1.

The main portion 124 being substantially parallel to the first demarcation line L1 described in the embodiments of the present disclosure means that both the main portion 124 and the first demarcation line L1 intersect a first reference line with a difference of no more than 2° in corresponding angles; and a point at which the first reference line intersects the first demarcation line L1 is a first intersection, and the first reference line is perpendicular to a tangent line at which the first intersection point is located.

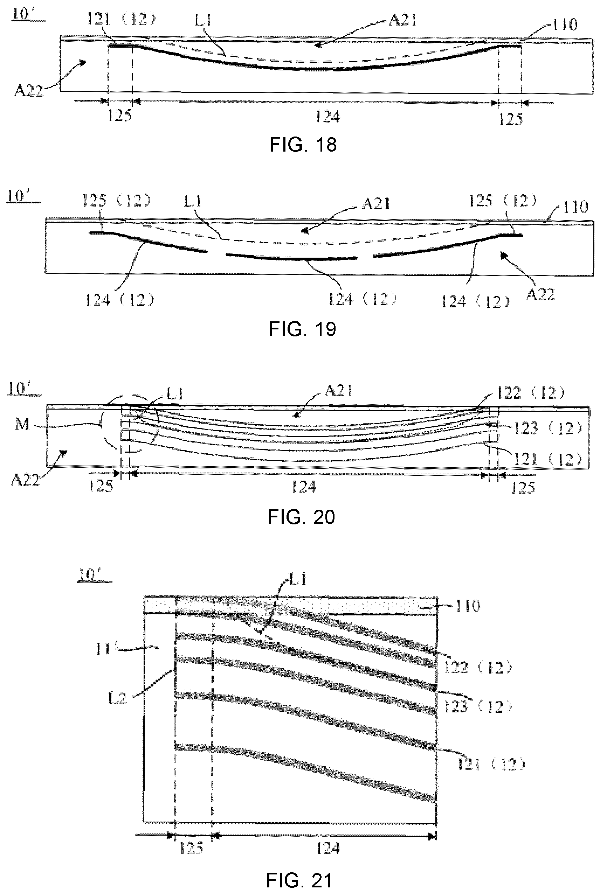

Exemplarily, referring to FIG. 18, there exists at least such a positioning structure 12, a main portion 124 of which is located in the peripheral region A22. A positioning structure 12 with a main portion 124 located in the peripheral region A22 is a first positioning structure 121, and the main portion 124 of the first positioning structure 121 is proximate to or away from a boundary of the functional device arrangement region A21 and is substantially parallel to the first demarcation line L1.

Exemplarily, referring to FIGS. 20 and 21, there exists at least such a positioning structure 12, a main portion 124 of which is located in the functional device arrangement region A21. A positioning structure 12 with a main portion 124 located in the functional device arrangement region A21 is a second positioning structure 122, and the main portion 124 of the second positioning structure 122 is proximate to or away from a boundary of an array region B and is substantially parallel to the first demarcation line L1.

Exemplarily, referring to FIGS. 20 and 21, there exists at least such a positioning structure 12, a part of a main portion 124 of which is located in the peripheral region A22 and the other part of the main portion 124 of which is located in the functional device arrangement region A21. A positioning structure 12 with a part of a main portion 124 located in the peripheral region A22 and the other part of the main portion 124 located in the functional device arrangement region A21 is a third positioning structure 123, and the main portion 124 of the third positioning structure 123 is located at a boundary of the functional device arrangement region A21 and at a boundary of the peripheral region A22, and is substantially parallel to the first demarcation line L1.

The positioning structure 12 described above is substantially a strip of uniform width, and the shape of the positioning structure 12 may be designed according to the first demarcation line L1.

Exemplarily, referring to FIGS. 16A to 20, an orthographic projection of the main portion 124 of the positioning structure 12 on the second reference plane is in any one of a straight-line shape, a right-angled U-shape (" 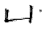 "-shape), a U-shape, and an arc-shape.

For example, as shown in FIG. 17, an orthogonal projection of the first demarcation line L1 on the second reference plane is substantially in a right-angled U-shape (" 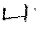 "-shape), and the orthographic projection of the main portion 124 of the positioning structure 12 on the second reference plane is substantially in a right-angled U-shape (" 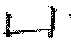 "-shape).

As another example, as shown in FIGS. 16A and 18, an orthogonal projection of the first demarcation line L1 on the second reference plane is substantially in an arc-shape), and the orthographic projection of the main portion 124 of the positioning structure 12 on the second reference plane is substantially in an arc-shape.

Some embodiments of the present disclosure are illustrated schematically below as an example in which the orthographic projection of the main portion 124 of the positioning structure 12 on the second reference plane is substantially in an arc-shape, but the implementations of the present disclosure are not limited thereto.

As shown in FIGS. 16A and 18, in a case where the orthographic projection of the main portion 124 of the positioning structure 12 on the second reference plane is substantially in an arc-shape, the positioning structure 12 may further include, for example, end portions 125 located at both ends of the main portion 124. The end portions 125 of the positioning structure 12 may be substantially parallel to a corresponding boundary of the array sub-board 10', so as to facilitate determining a distance between the positioning structure 12 and the corresponding boundary of the array sub-board 10', i.e., the distance indicated by the positioning structure 12.

The width of the above-described positioning structure 12 may be set according to the actual situation. Exemplarily, the width of the positioning structure 12 is in a range of 5 µm to 50 µm, inclusive. For example, the width of the positioning structure 12 is any one of 5 µm, 10 µm, 15 µm, 20 µm, 25 µm, 30 µm, 35 µm, 40 µm, 45 µm, and 50 µm, and the embodiments of the present disclosure are not specifically limited herein.

It should be understood that during a process of removing the portion of the array sub-board 10' located in the functional device arrangement region A21 by the grinding process, a grinding boundary is substantially parallel to the first demarcation line L1, i.e., the positioning structure 12 is substantially parallel to the grinding boundary. In this way, an actual grinding amount of the grinding process can be obtained by obtaining a distance between the positioning structure 12 and the grinding boundary, and then subtracting the distance between the positioning structure 12 and the grinding boundary from the distance indicated by the positioning structure 12.

Here, there exists at least such a positioning structure 12, at least a part of a main portion 124 of which is located in the peripheral region A22; and a boundary, located in the peripheral region A22, of this positioning structure 12 has a maximum distance with the first demarcation line L1, where the maximum distance is greater than a first preset value and less than or equal to a second preset value.

It will be noted that there may be one boundary, located in the peripheral region A22, of a main portion 124 of a positioning structure 12, i.e., the main portion 124 of the positioning structure 12 is completely located in the peripheral region A22; or there may be two boundaries, located in the peripheral region A22, of a positioning structure 12, i.e., a part of a main portion 124 of the positioning structure 12 is located in the peripheral region A22 and a part of the main portion 124 of the positioning structure 12 is located in the functioning device arrangement region A21.

In a case where a main portion 124 of a positioning structure 12 is completely located in the peripheral region A22, the maximum distance is a distance between a boundary of this positioning structure 12 located in the peripheral region A22 and the first demarcation line L1. In a case where a part of a main portion 124 of a positioning structure 12 is located in the peripheral region A22 and a part of the main portion 124 of the positioning structure 12 is located in the functioning device arrangement region A21, the maximum distance is a distance between a boundary of this positioning structure 12 away from the first demarcation line L1 and the first demarcation line L1.

The first preset value is a process accuracy at which a portion, located in the functional device arrangement region A21, of an array sub-board 10' is capable of being removed. Exemplarily, the first preset value is in a range of 0.02 mm to 0.1 mm, inclusive. For example, the first preset value is any one of 0.02 mm, 0.03 mm, 0.04 mm, 0.05 mm, 0.06 mm, 0.07 mm, 0.08 mm, 0.09 mm, and 0.1 mm, and embodiments of the present disclosure are not specifically limited herein.

The second preset value is a minimum distance between the light-emitting region A1 and the first demarcation line L1. Exemplarily, the second preset value is in a range of 0.4 mm to 0.6 mm, inclusive. For example, the second preset value is any one of 0.4 mm, 0.45 mm, 0.46 mm, 0.48 mm, 0.5 mm, 0.52 mm, 0.55 mm, 0.58 mm, and 0.6 mm, and embodiments of the present disclosure are not specifically limited herein.

In this case, the actual grinding amount of the grinding process can be obtained by the positioning structure 12, and the actual grinding amount may be compared with a preset grinding amount, so as to facilitate the removal of unqualified products whose actual grinding amount is not within a range of the preset grinding amount, preventing the unqualified products from escaping into the marketplace. Moreover, the grinding equipment can be monitored and controlled by obtaining the actual grinding amount of the grinding process in real-time, and the grinding equipment can be adjusted in time if the actual grinding amount is not within the range of the preset grinding amount, so as to make the actual grinding amount meet the preset grinding amount requirements, improving the product yield rate.

The above preset grinding amount may be, for example, a maximum distance between the first demarcation line L1 and a portion, corresponding to the functional device arrangement region A21, of the boundary of the array sub-board 10'. Exemplarily, the preset grinding amount is in a range of 1 mm to 2 mm, inclusive. For example, the preset grinding amount is in a range of 1.3 mm to 1.4 mm, inclusive, and the embodiments of the present disclosure are not specifically limited herein.

In this case, the range of the preset grinding amount may be, for example, a range formed by this maximum distance and the process accuracy of the grinding (i.e., the first preset value). Exemplarily, the preset grinding amount is 1 mm, the first preset value is 0.05 mm, and the range of the preset grinding amount is in a range of 0.95 mm to 1.05 mm, inclusive, and the embodiments of the present disclosure are not limited thereto.

Referring to FIG. 18, for a same indicated distance, a single positioning structure 12 may be provided. Referring to FIG. 19, for the same indicated distance, multiple positioning structures 12 spaced may also be provided.

Here, in a case where for the same indicated distance, multiple positioning structures 12 spaced are provided, as shown in FIG. 19, a positioning structure 12 among the multiple positioning structures 12 located at an edging may, for example, further include an end portion 125. The end portion 125 is located at an end of a main portion 124 of this positioning structure 12 away from other positioning structures 12, and the end portion 125 may be substantially parallel to a corresponding boundary of the array sub-board 10', so as to facilitate obtaining a distance between this positioning structure 12 and the boundary corresponding to the array sub-board 10', i.e., the distance indicated by the positioning structure 12.

Some embodiments of the present disclosure are illustrated schematically below as an example in which a single positioning structure 12 is provided for the same indicated distance, but embodiments of the present disclosure are not limited thereto.

In some examples, as shown in FIG. 18, the main portion 124 of the first positioning structure 121 may, for example, surround the first demarcation line L1, and the first demarcation line L1 is located between two end portions 125 of the first positioning structure 121.

In this way, in the process of removing, by a grinding process, a portion of the array sub-board 10' that is located within a region enclosed by the first positioning structure 121, the corresponding first positioning structure 121 is present at any position of the grinding boundary, facilitating the acquisition of a distance between the first positioning structure 121 and the grinding boundary.

In some examples, referring to FIGS. 20 and 21, the first demarcation line L1 may, for example, surround the main portion 124 of the second positioning structure 122, and the first demarcation line L1 is located between two end portions 125 of the second positioning structure 122.

In this way, in the process of removing, by a grinding process, a portion of the array sub-board 10' that is located within a region enclosed by the second positioning structure 122, the corresponding second positioning structure 122 is present at any position of the grinding boundary, facilitating the acquisition of a distance between the second positioning structure 122 and the grinding boundary.

In some examples, referring to FIGS. 20 and 21, the main portion 124 of the third positioning structure 123 may, for example, cover the first demarcation line L1, and the first demarcation line L1 is located between two end portions 125 of the third positioning structure 123.

In this way, in the process of removing, by a grinding process, a portion of the array sub-board 10' that is located within a region enclosed by the third positioning structure 123, the corresponding third positioning structure 123 is present at any position of the grinding boundary, facilitating the acquisition of a distance between the third positioning structure 123 and the grinding boundary.

The length of the positioning structure 12 may be set according to the length of the first demarcation line L1.

In some examples, a distance between both ends of the positioning structure 12 is in a range of 16 mm to 30 mm, inclusive. For example, the distance between both ends of the positioning structure 12 is any one of 16 mm, 17 mm, 17.5 mm, 18 mm, 19 mm, 19.7 mm, 20 mm, 20.5 mm, 21 mm, 21.1 mm, 21.5 mm, 22 mm, 22.3 mm, 23 mm, 23.5 mm, 24 mm, 24.5 mm, 25 mm, 25.5 mm, 26 mm, 27 mm, 28 mm, 29 mm, and 30 mm, and embodiments of the present disclosure are not specifically limited herein.

In some examples, a distance between both ends of the positioning structure 12 is in a range of 61 mm to 75 mm, inclusive. For example, the distance between both ends of the positioning structure 12 is any one of 61 mm, 61.5 mm, 62 mm, 63.1 mm, 64.5 mm, 65 mm, 65.3 mm, 65.6 mm, 66 mm, 67 mm, 67.5 mm, 68 mm, 69 mm, and 70 mm.

In some embodiments, as shown in FIG. 18, the array sub-board 10' includes a single positioning structure 12 that is located in the peripheral region A22, and a maximum distance between a boundary of the positioning structure 12 and the first demarcation line L1 is greater than a first preset value. For example, the first preset value is 0.05 mm, and the maximum distance between the boundary of the positioning structure 12 and the first demarcation line L1 is 0.06 mm.

In some other embodiments, as shown in FIGS. 20 and 21, the array sub-board 10' includes a plurality of positioning structures 12; and among the plurality of positioning structures 12, there exists at least one case that a distance between two adjacent positioning structures 12 of one group is not equal to a distance between two adjacent positioning structures 12 of another group.

Exemplarily, as shown in FIGS. 20 and 21, the array sub-board 10' includes 6 positioning structures 12, and a distance between the 6 positioning structures 12 becomes stepwise larger from the outer side of the array sub-board 10' to the inner side of the array sub-board 10'. For example, from the outer side of the array sub-board 10' to the inner side of the array sub-board 10', distances each between every two adjacent positioning structures 12 of the 6 positioning structures 12 are 0.03 mm, 0.05 mm, 0.05 mm, 0.07 mm, and 0.11 mm, respectively.

In some examples, as shown in FIG. 21, among the plurality of positioning structures 12, both ends of a positioning structure 12 furthest from a center of the array sub-board 10' extend to a boundary of the array sub-board 10', and end portions 125 of this positioning structure 12 are substantially flush with the boundary of the array sub-board 10'.

In some examples, as shown in FIG. 21, same ends of the plurality of positioning structures 12 are connected to form a first line segment L2, and a line where the first line segment L2 is in intersects with and is substantially perpendicular to a boundary of the peripheral region A22. The term "substantially perpendicular" includes absolute perpendicularity and approximate perpendicularity, where an acceptable range of deviation of the approximate perpendicularity may be, for example, a deviation within 3°.

In some examples, as shown in FIG. 21, among the plurality of positioning structures 12, there exists at least such a positioning structure 12 whose main portion 124 has an orthographic projection on a second reference plane substantially overlapping with an orthogonal projection of the first demarcation line L1 on the second reference plane.

It will be noted that the second reference plane is a plane where a surface of the substrate motherboard 11' away from the positioning structures 12 is located.

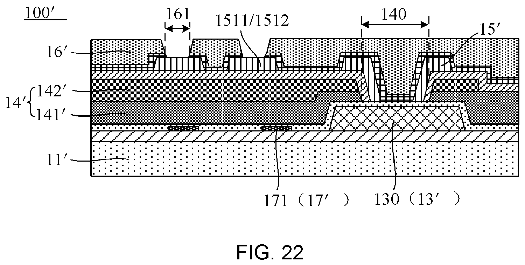

In some embodiments, referring to FIG. 22, the above-described array motherboard 100' includes a first metal film 13', a first insulating film 14', a second metal film 15', and a second insulating film 16'.

Referring to FIG. 22, the first metal film 13' is provided on a side of the substrate motherboard 11'. A material of the first metal film 13' includes at least one of copper, aluminum, and silver.

Here, referring to FIGS. 5 and 22, the first metal film 13' includes a plurality of signal lines 130. The plurality of signal lines 130 may include, for example, device power supply signal lines 131, common voltage lines 132, data signal lines 133, clock signal lines 134, feedback signal lines 135, address signal lines 136, and chip power supply signal lines 137.

Referring to FIG. 22, the first insulating film 14' is provided on a side of the first metal film 13' away from the substrate motherboard 11'. Here, the first insulating film 14' is provided with first via holes 140 penetrating the first insulating film 14'. A material of the first insulating film 14' includes a resin. For example, the material of the first insulating film 14' includes an epoxy resin.

In some examples, as shown in FIG. 22, the first insulating film 14' includes a first insulating sub-film 141' and a second insulating sub-film 142' that are provided in a stack, where the first insulating sub-film 141' is closer to the first metal film 13' relative to the second insulating sub-film 142'.

In such an arrangement, the first insulating sub-film 141' and the second insulating sub-film 142' may be formed separately in a two-step process, and microcracks generated in the process of the first insulating sub-film 141' and the second insulating sub-film 142' form a mismatch, which reduces the risk of the microcracks penetrating through the first insulating film 14', and reduces the risk of the intrusion of the water vapor.

Referring to FIG. 22, the second metal film 15' is provided on a side of the first insulating film 14' away from the substrate motherboard 11'. A material of the second metal film 15' includes at least one of copper, aluminum, and silver.

Here, the second metal film 15' includes a plurality of conductive portions 151 and a plurality of transfer lines 152. A transfer line 152 is connected to a conductive portion 151 and is in electrical contact with a signal line 131 through a first via hole 140.

Exemplarily, referring to FIGS. 6, 7, and 22, the plurality of conductive portions 151 may include, for example, device conductive portions 1511, chip conductive portions 1512, test portions 1513, and bonding portions 1514. The device conductive portions 1511 and the chip conductive portions 1512 are located in the light-emitting region A1, the test portions 1513 are located in the test region A2, and the bonding portions 1514 are located in the bonding region A3.

In this case, referring to FIG. 7, the above-described positioning structure 12 may, for example, be located in the test region A2 and between two adjacent bonding portions 1514.

Exemplarily, referring to FIGS. 6 and 7, the plurality of transfer lines 152 may, for example, include first transfer lines 1521, second transfer lines 1522, third transfer lines 1523, fourth transfer lines 1524, and fifth transfer lines 1525.

As shown in FIGS. 6 and 7, of a first transfer line 1521, one end may be connected to, for example, a signal line 130 and the other end is connected to a device conductive portion 1511; of a second transfer line 1522, one end may be connected to, for example, a device conductive portion 1511 and the other end to another device conductive portion 1511; of a third transfer line 1523, one end may be connected to, for example, a device conductive portion 1511 and the other end to a chip conductive portion 1512; of a fourth transfer line 1524, one end may be connected to, for example, a signal line 130 and the other end to a chip conductive portion 1512; and of a fifth transfer line 1525, one end may, for example, be connected to a signal line 130, and the other end to a test portion 1513.

Referring to FIG. 22, the second insulating film 16' is provided on a side of the second metal film 15' away from the substrate motherboard 11'. The second insulating film 16' is provided with second via holes 161 penetrating the second insulating film 16', and a second via hole 161 exposes at least a partial region of a conductive portion 151. A material of the second insulating film 16' includes a resin. For example, the material of the second insulating film 16' includes an epoxy resin.

It will be noted that a portion of the conductive portion 151 that is exposed by the second via hole 161 serves as a bonding pad.

Based on the foregoing, referring to FIGS. 20 and 22, a positioning structure 12 may be located in any one of the first metal film 13', the second metal film 15', the first insulating film 14', and the second insulating film 16'.

Exemplarily, referring to FIGS. 20 and 22, the first positioning structure 121 is located in any one of the first metal film 13', the second metal film 15', the first insulating film 14', and the second insulating film 16'. The second positioning structure 122 is located in the first insulating film 14' or the second insulating film 16'. The third positioning structure 123 is located in the first insulating film 14' or the second insulating film 16'.

It should be understood that during the process of removing a portion of the array sub-board 10' that is located within a region enclosed by the third positioning structure 123, the positioning structures 12, i.e., the second positioning structure 122 and the third positioning structure 123, that are located in the functional device arrangement region A22, will be both removed simultaneously.

In this way, referring to FIGS. 20 and 22, the second positioning structure 122 and the third positioning structure 123 are located in the first insulating film 14' or the second insulating film 16'. The second positioning structure 122 and the third positioning structure 123 can still be used to prevent water and oxygen erosion even when exposed to a grinding surface, improving the reliability of the formed array substrate 10.

In some embodiments, referring to FIG. 22, the above-described array motherboard 100' includes an alignment mark film 17', and the alignment mark film 17' is provided between the first metal film 13' and the substrate motherboard 11'. A material of the alignment mark film 17' includes a metal or dark-colored (e.g., black, brown, tan, green, etc.) material. For example, the material of the alignment mark film 17' includes at least one of molybdenum, titanium, and niobium. The material of the alignment mark film 17' may also include at least one of a dark-colored resin and a dark-colored ink.

As shown in FIG. 22, the above-described alignment mark film 17' includes at least one alignment mark 171 to facilitate alignment by capturing an image of the alignment mark 171 during the process.

In this case, referring to FIGS. 20 and 22, the above-described first positioning structure 121, second positioning structure 122, and third positioning structure 123 may also be located in the alignment mark film 17'.

In a case where the array sub-board 10' includes a plurality of positioning structures 12, all of the positioning structures 12 may be of the same material and be located in the same layer in order to reduce production costs. Of course, different positioning structures 12 may also be located in different layers, respectively, and embodiments of the present disclosure are not specifically limited herein.

Furthermore, in a case where the array sub-board 10' includes a single positioning structure 12 that is located in the peripheral region A22, this positioning structure 12 may, for example, be located in any one of the first metal film 13', the second metal film 15' and the alignment mark film 17', so as to facilitate detection of a distance between this positioning structure 12 and the grinding boundary by an automated optical inspection (AOI) equipment.

Some embodiments of the present disclosure provide an array substrate 10, which can be obtained from the above-described array motherboard 100' by processes such as cutting.

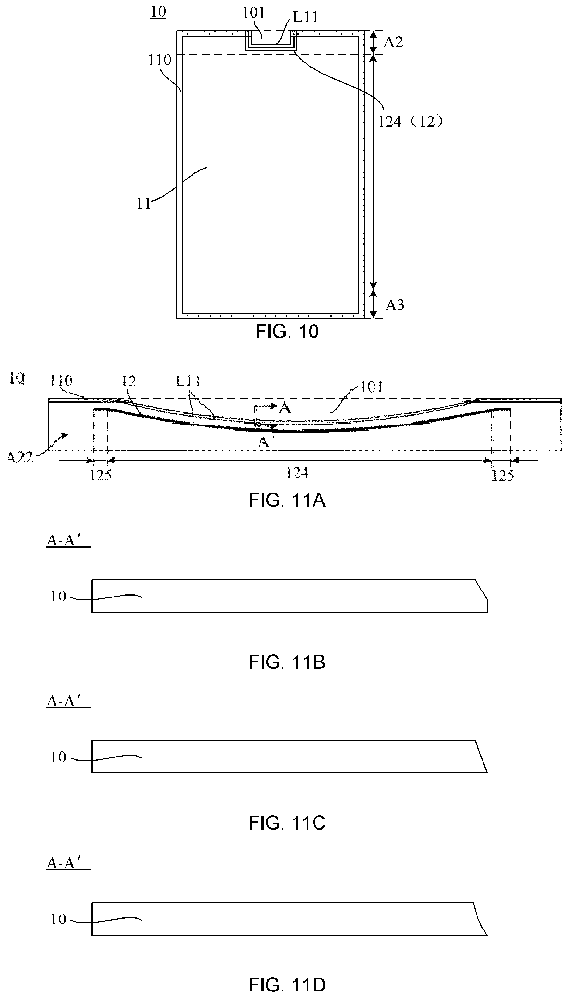

Referring to FIGS. 9 and 10, the array substrate 10 is provided with at least one avoidance notch 101 at an edging thereof. The above-described functional device 400 is provided at the avoidance notch 101 of the array substrate 10 to avoid the interference between the functional device 400 and the array substrate 10, thereby avoiding the pushing between the functional device 400 and the array substrate 10, reducing the risk of deformation in the array substrate 10 or the risk of failure of the functional device.

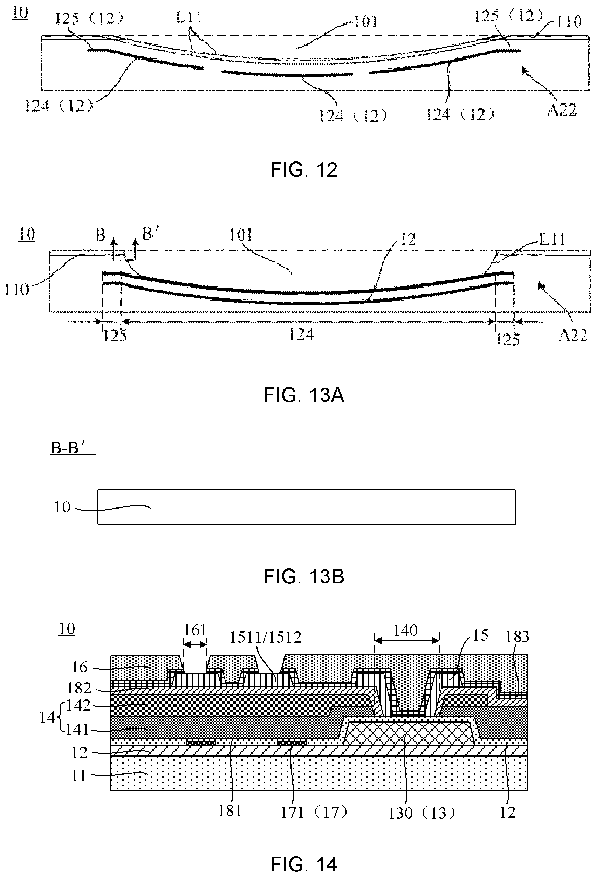

In some examples, referring to FIGS. 13A and 13B, a surface of the avoidance notch 101 formed by the grinding process is a plane perpendicular to the array substrate 10, and an orthographic projection of the avoidance notch 101 on a first reference plane has a first edge L11.

It will be noted that the first reference plane is a plane where a surface, away from the display panel 100, of the array substrate 10 is located, and the first reference plane is the same plane as the second reference plane mentioned above.

In some other examples, referring to FIGS. 11A, 11B, 11C, and 11D, a surface of the avoidance notch 101 formed by the grinding process has a beveled or curved surface, and an orthographic projection of the surface of the avoidance notch 101 on the first reference plane has two first edges L11. In this case, a distance between the two first edges L11 is in a range of approximately 50 µm to approximately 150 µm. For example, the distance between the two first edges L11 is any one of 50 µm, 60 µm, 70 µm, 80 µm, 90 µm, 100 µm, 110 µm, 120 µm, 130 µm, 140 µm, and 150 µm, and the embodiments of the present disclosure are not specifically limited herein.

The shape of the above avoidance notch 101 can be set according to the shape and position of the functional device 400.

Exemplarily, referring to FIGS. 9 and 10, the first edge L11 of the orthographic projection of the avoidance notch 101 on the first reference plane is substantially in any one of a right-angled U-shape (" 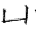 "-shape), a U-shape, and an arc-shape.

For example, as shown in FIG. 9, the first edge L11 of the orthographic projection of the avoidance notch 101 on the first reference plane is substantially in an arc-shape.

As used herein, "substantially in an arc-shape" means that the shape of a described object is in an arc-shape as a whole, but is not limited to a standard arc-shape. That is to say, the "arc" here includes not only a curve with the same curvature at all positions, but also a smooth curve. It can be understood that in the actual preparation of the avoidance notch, grinding or laser cutting may be used, and in some cases, the obtained first edge L11 is composed of multiple folded segments connected end to end, having an approximate arc shape.

As another example, as shown in FIG. 10, the first edge L11 of the orthographic projection of the avoidance notch 101 on the first reference plane is substantially in a right-angled U-shape (" 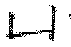 "-shape).

Some embodiments of the present disclosure are illustrated schematically below as an example in which the first edge L11 of the orthographic projection of the avoidance notch 101 on the first reference plane is substantially in an arc-shape, but the embodiments of the present disclosure are not limited thereto.

The area of the above-described avoidance notch 101 may be set according to the area and shape of the functional device 400.

In some examples, a distance between both ends of the first edge L11 of the orthographic projection of the avoidance notch 101 on the first reference plane is in a range of 15 mm to 25 mm, inclusive. For example, a distance between both ends of a boundary of the avoidance notch 101 is any one of 15 mm, 16 mm, 16.5 mm, 17 mm, 18 mm, 18.7 mm, 19 mm, 19.5 mm, 20 mm, 20.1 mm, 20.5 mm, 21 mm, 21.3 mm, 22 mm, 22.5 mm, 23 mm, 23.5 mm, 24 mm, 24.5 mm, and 25 mm, and embodiments of the present disclosure are not specifically limited herein.

In some examples, a distance between both ends of the first edge L11 of the orthographic projection of the avoidance notch 101 on the first reference plane is in a range of 60 mm to 70 mm, inclusive. For example, a distance between both ends of the first demarcation line L1 is any one of 60 mm, 60.5 mm, 61 mm, 62.1 mm, 63.5 mm, 64 mm, 64.3 mm, and 65 mm, and embodiments of the present disclosure are not specifically limited herein.

In some examples, a portion, corresponding to a functional device arrangement region A21, of a boundary of an array sub-board 10' has a maximum distance from the boundary of the avoidance notch 101 in a range of 1 mm to 2 mm, inclusive. For example, the maximum distance between the portion, corresponding to the functional device arrangement region A21, of the boundary of the array sub-board 10' and the boundary of the avoidance notch 101 is any one of 1 mm, 1.1 mm, 1.2 mm, 1.3 mm, 1.35 mm, 1.355 mm, 1.4 mm, 1.45 mm, 1.5 mm, 1.6 mm, 1.7 mm, 1.8 mm, 1.9 mm, and 2 mm, and the embodiments of the present disclosure are not specifically limited herein.

Referring to FIGS. 9 and 10, the edging of the array substrate 10 may be provided with a single avoidance notch 101. Alternatively, referring to FIG. 8, the edging of the array substrate 10 may be provided with multiple avoidance notches 101, in which each of the avoidance notches 101 may allow multiple functional devices 400 or a single functional device 400 to be provided therein.

In some examples, as shown in FIGS. 1 and 10, the edging of the array substrate 10 is provided with one avoidance notch 101, and multiple functional devices 400 are provided within the one avoidance notch 101.

In some other examples, as shown in FIGS. 2 and 8, the edging of the array substrate 10 is provided with five avoidance notches 101, and one functional device 400 is provided within one avoidance notch 101.

Here, as shown in FIG. 8, a distance between two adjacent avoidance notches 101 along an extending direction of the edging of the array substrate 10 is in a range of 100 mm to 120 mm, inclusive.

Exemplarily, along the extending direction of the edging of the array substrate 10, the distance between the two adjacent avoidance notches is any one of 100 mm, 101 mm, 104 mm, 105 mm, 108 mm, 110 mm, 113 mm, 115 mm, 117 mm, 118 mm, and 120 mm, and embodiments of the present disclosure are not specifically limited herein.

Furthermore, in a case where the array substrate 10 is substantially in a rectangular shape, the multiple avoidance notches 101 may be provided at the same edging of the array substrate 10 as shown in FIG. 8. And, two avoidance notches 101, located on two opposite sides, of the multiple avoidance notches 101 each have a range of 10 mm to 20 mm in distance from another edging adjacent thereto.

Exemplarily, the distance between each of the two avoidance notches 101, located on two opposite sides, of the multiple avoidance notches 101 and another edging adjacent thereto is any one of 10 mm, 11 mm, 12.5 mm, 14 mm, 15 mm, 15.5 mm, 16 mm, 17.5 mm, 18 mm, 18.5 mm, 19 mm, and 20 mm, and embodiments of the present disclosure are not specifically limited herein.

Some embodiments of the present disclosure are illustrated schematically below as an example in which the edging of the array substrate 10 is provided with a single avoidance notch 101, but the embodiments of the present disclosure are not limited thereto.

In some embodiments, referring to FIGS. 8 to 10, the array substrate 10 includes a substrate 11 and at least one positioning structure 12. In this case, the first reference plane is a plane where a surface of the substrate 11 away from the positioning structure 12 is located.

It will be noted that the material of the substrate 11 can be referred to that of the substrate motherboard 11' mentioned above, and the embodiments of the present disclosure will not be repeated herein.

As shown in FIGS. 8 to 10, the positioning structure 12 is provided on a side of the substrate 11, and the positioning structure 12 includes a main portion 124, the main portion 124 being substantially parallel to the first edge L11.

Here, the main portion 124 being substantially parallel to the first edge L11 means that both the main portion 124 and the first edge L11 intersect a second reference line with a difference of no more than 2° in corresponding angles; and a point at which the second reference line intersects the first edge L11 is a second intersection, and the second reference line is perpendicular to a tangent line at which the second intersection point is located.

It will be noted that the shape of the positioning structure 12 can be referred to hereinabove, and embodiments of the present disclosure are not repeated herein.

As shown in FIGS. 9 and 11A, in a case where an orthographic projection of the main portion 124 of the positioning structure 12 on the second reference plane is substantially in an arc-shape, the positioning structure 12 may further include, for example, end portions 125 located at both ends of the main portion 124. The end portions 125 of the positioning structure 12 may be substantially parallel to a corresponding boundary of the array substrate 10, to facilitate obtaining a distance between the positioning structure 12 and the corresponding boundary of the array substrate 10, i.e., the distance indicated by the positioning structure 12.

In such an arrangement, a position of the boundary of the avoidance notch 101 can be obtained by obtaining a distance between the positioning structure 12 and the avoidance notch 101, and then subtracting the distance between the positioning structure 12 and the avoidance notch 101 from the distance indicated by the positioning structure 12. In this case, the position of the boundary of the avoidance notch 101 is compared with the range of the preset grinding amount, so as to facilitate the removal of unqualified products whose avoidance notch 101 is not in the preset position, preventing the unqualified products from escaping into the marketplace.

It will be noted that the range of the preset grinding amount can be referred to hereinabove, and the embodiments of the present disclosure will not be repeated herein.

Referring to FIG. 11A, for a same indicated distance, a single positioning structure 12 may be provided. Referring to FIG. 12, for the same indicated distance, multiple positioning structures 12 spaced may also be provided.

Here, in a case where for the same indicated distance, multiple positioning structures 12 spaced are provided, as shown in FIG. 12, a positioning structure 12 among the multiple positioning structures 12 located at an edging may, for example, further include an end portion 125. The end portion 125 is located at an end of a main portion 124 of this positioning structure 12 away from other positioning structures 12, and the end portion 125 may be substantially parallel to a corresponding boundary of the array substrate 10, so as to facilitate obtaining a distance between this positioning structure 12 and the boundary corresponding to the array substrate 10, i.e., the distance indicated by the positioning structure 12.

Some embodiments of the present disclosure are illustrated schematically below as an example in which a single positioning structure 12 is provided for the same indicated distance, but embodiments of the present disclosure are not limited thereto.

In some examples, as shown in FIG. 11A, the main portion 124 of the positioning structure 12 may, for example, surround the avoidance notch 101, and the avoidance notch 101 is located between two end portions 125 of the positioning structure 12. In such an arrangement, the corresponding third positioning structure 123 is present at any position of the boundary of the avoidance notch 101, facilitating the acquisition of a distance between the positioning structure 12 and the boundary of the avoidance notch 101.

In some embodiments, referring to FIG. 11A, the array substrate 10 includes a single positioning structure 12. In some other embodiments, referring to FIG. 13A, the array substrate 10 includes a plurality of positioning structures 12. An example in which the array substrate 10 includes 2 positioning structures 12 is illustrated in FIG. 13A.

In some embodiments, referring to FIG. 14, the above-described array substrate 10 includes a first conductive metal layer 13, a first insulating layer 14 and a second conductive metal layer 15.

Referring to FIG. 14, the first conductive metal layer 13 is provided on a side of the substrate 11. A material of the first conductive metal layer 13 includes at least one of copper, aluminum, and silver.

Here, referring to FIGS. 5 and 14, the first conductive metal layer 13 includes a plurality of signal lines 130. Specific descriptions of the plurality of signal lines 130 can be found as described above, and the embodiments of the present disclosure will not be repeated herein.

Referring to FIG. 14, the first insulating layer 14 is provided on a side of the first conductive metal layer 13 away from the substrate 11. Here, the first insulating layer 14 is provided with first via holes 140 penetrating the first insulating layer 14. A material of the first insulating layer 14 includes a resin. For example, the material of the first insulating layer 14 includes an epoxy resin.

In some examples, as shown in FIG. 14, the first insulating layer 14 includes a first insulating sub-layer 141 and a second insulating sub-layer 142 that are provided in a stack, where the first insulating sub-layer 141 is closer to the first conductive metal layer 13 relative to the second insulating sub-layer 142.

In such an arrangement, the first insulating sub-layer 141 and the second insulating sub-layer 142 may be formed separately in a two-step process, and microcracks generated in the process of the first insulating sub-layer 141 and the second insulating sub-layer 142 form a mismatch, which reduces the risk of the microcracks penetrating through the first insulating layer 14, and reduces the risk of the intrusion of the water vapor.

Referring to FIG. 14, the second conductive metal layer 15 is provided on a side of the first insulating layer 14 away from the substrate 11. A material of the second conductive metal layer 15 includes at least one of copper, aluminum, and silver.

Here, the second conductive metal layer 15 includes a plurality of conductive portions 151 and a plurality of transfer lines 152. Specific descriptions of the conductive portions 151 and transfer lines 152 can be found as described above, and the embodiments of the present disclosure will not be repeated herein.

Based on the above, referring to FIGS. 13A and 14, the positioning structure 12 is located in any one of the first conductive metal layer 13, the second conductive metal layer 15, and the first insulating layer 14.

Exemplarily, referring to FIGS. 13A and 14, a side, proximate to the avoidance notch 101, of the main portion 124 of the positioning structure 12 is exposed by the avoidance notch 101, and the positioning structure 12 may, for example, be located in the first insulating layer 14, such that in a case of being exposed to the grinding surface, the positioning structure 12 can still also be used to prevent water-oxygen erosion, improving the reliability of the array substrate 10.

It will be noted that the main portion 124 of the positioning structure 12 may not be exposed by the avoidance notch 101. In this case, the positioning structure 12 may be located in any one of the first conductive metal layer 13, the second conductive metal layer 15 and the first insulating layer 14, and embodiments of the present disclosure are not specifically limited herein.

In some embodiments, referring to FIG. 14, the above-described array substrate 10 further includes a first passivation layer 181, a second passivation layer 182, and a third passivation layer 183.

As shown in FIG. 14, the first passivation layer 181 is provided between the first conductive metal layer 13 and the first insulating layer 14; the second passivation layer 182 is provided between the second conductive metal layer 15 and the first insulating layer 14; and the third passivation layer 183 is provided on a side of the second conductive metal layer 15 away from the substrate 11.

Materials of the first passivation layer 181, the second passivation layer 182, and the third passivation layer 183 described above may each include at least one of inorganic insulating materials such as silicon nitride, silicon nitride oxide, and silicon oxide. Exemplarily, the material of the first passivation layer 181, the second passivation layer 182, and the third passivation layer 183 includes silicon nitride.

In some embodiments, referring to FIG. 14, the above array substrate 10 further includes a second insulating layer 16, the second insulating layer 16 being provided on a side of the second conductive metal layer 15 away from the substrate 11. The second insulating layer 16 is provided with second via holes 161 penetrating the second insulating layer 16, where a second via hole 161 exposes at least a partial region of a conductive portion 151. A material of the second insulating layer 16 includes resin. For example, the material of the second insulating film 16' includes epoxy resin.

In this case, the above-described positioning structure 12 may also be located in the second insulating layer 16. Exemplarily, referring to FIG. 14, a side, proximate to the avoidance notch 101, of the main portion 124 of the positioning structure 12 is exposed by the avoidance notch 101, and the positioning structure 12 may, for example, be located in the first insulating layer 14, such that in a case of being exposed to the grinding surface, the positioning structure 12 can still also be used to prevent water-oxygen erosion, improving the reliability of the array substrate 10.

In some examples, referring to FIGS. 13A and 14, the positioning structure 12 is located in the first conductive metal layer 13; and of the first insulating layer 14, the first passivation layer 181, the second passivation layer 182, the third passivation layer 183, and the second insulating layer 16 described above, at least one layer covers the test region A2 (refer to FIG. 6), to avoid the positioning structure 12 being exposed, thereby reducing the risk of generating static electricity by the positioning structure 12.

In some other examples, referring to FIGS. 13A and 14, the positioning structure 12 is located in the first conductive metal layer 13, and the first insulating layer 14, the first passivation layer 181, the second passivation layer 182, the third passivation layer 183, and the second insulating layer 16 are all provided, for example, in the light-emitting region A1 (refer to FIG. 6), and expose the test region A2 (refer to FIG. 6). On this basis, the array substrate 10 may further include a third insulating layer, the third insulating layer covering the positioning structure 12 to avoid the positioning structure 12 being exposed, thereby reducing the risk of generating static electricity by the positioning structure 12.

In some examples, referring to FIGS. 13A and 14, the positioning structure 12 is located in the second conductive metal layer 15; and the third passivation layer 183 and/or the second insulating layer 16 described above cover the test region A2 to avoid the positioning structure 12 being exposed, thereby reducing the risk of generating static electricity by the positioning structure 12.

In some other examples, referring to FIGS. 13A and 14, the positioning structure 12 is located in the second conductive metal layer 15, and the third passivation layer 183 and the second insulating layer 16 are both provided, for example, in the light-emitting region A1 (refer to FIG. 6), and expose the test region A2 (refer to FIG. 6). On this basis, the array substrate 10 may further include a third insulating layer, the third insulating layer covering the positioning structure 12 to avoid the positioning structure 12 being exposed, thereby reducing the risk of generating static electricity by the positioning structure 12.

In some embodiments, referring to FIG. 14, the above-described array substrate 10 further includes an alignment mark layer 17, the alignment mark layer 17 being provided between the first conductive metal layer 13 and the substrate 11. A material of the alignment mark layer 17 may have a high reflectivity or a non-transparent color that is easily recognizable in visible light, such as a metal or a dark material. For example, the material of the alignment mark layer 17 includes at least one of molybdenum, titanium, and niobium. The material of the alignment mark film 17' may also include at least one of a dark-colored resin and a dark-colored ink.

As shown in FIG. 14, the alignment mark layer 17 includes at least one alignment mark 171 to facilitate alignment by capturing an image of the alignment mark 171 during the process.

In this case, the above-described positioning structure may also be located in the alignment mark layer 17.

Here, in a case where the array substrate 10 includes a plurality of positioning structures 12, all of the positioning structures 12 may be of the same material and be located in the same layer to reduce production costs. Of course, different positioning structures 12 may also be located in different layers, respectively, and the embodiments of the present disclosure are not specifically limited herein.

Furthermore, in a case where the array substrate 10 includes a single positioning structure 12, this positioning structure 12 may, for example, be located in any one of the first conductive metal layer 13, the second conductive metal layer 15 and the alignment mark layer 17, so as to facilitate detection of a distance between this positioning structure 12 and the boundary of the avoidance notch 101 by an automated optical inspection (AOI) equipment.

In some embodiments, referring to FIG. 14, the above-described array substrate 10 further includes a buffer layer 19, the buffer layer 19 being provided between the alignment mark layer 17 and the substrate 11 to serve as a buffer to protect the substrate 11.

A material of the buffer layer 19 includes an inorganic insulating material. Exemplarily, the material of the buffer layer 19 includes silicon oxide and/or silicon nitride. For example, the material of the buffer layer 19 includes silicon nitride.

In the description of the present specification, specific features, structures, materials, or characteristics may be combined in any one or more embodiments or examples in a suitable manner.

The foregoing description is only specific embodiments of the present disclosure, but the scope of protection of the present disclosure is not limited thereto. Any changes or replacements that a person skilled in the art could conceive of within the technical scope of the present disclosure shall be included in the protection scope of the present disclosure. Therefore, the protection scope of the present disclosure shall be subject to the protection scope of the claims.

## Claims

1. An array substrate, wherein the array substrate is provided with an avoidance notch at an edging of the array substrate, an orthographic projection of the avoidance notch on a first reference plane having a first edge; and the array substrate comprises:
a substrate; and
at least one positioning structure, provided on a side of the substrate, wherein a positioning structure includes a main portion, the main portion being substantially parallel to the first edge; and the first reference plane is a plane where a surface, away from the positioning structure, of the substrate is located.

2. The array substrate according to claim 1, wherein the first edge of the orthographic projection of the avoidance notch on the first reference plane is in an arc-shape, and an orthographic projection of the positioning structure on the first reference plane is in an arc-shape.

3. The array substrate according to claim 2, wherein the positioning structure further includes end portions located at both ends of the main portion, and the end portions of the positioning structure are substantially parallel to a corresponding boundary of the array substrate.

4. The array substrate according to claim 3, wherein the main portion of the positioning structure surrounds the avoidance notch, and the avoidance notch is located between the two end portions of the positioning structure.

5. The array substrate according to any one of claims 1 to 4, further comprising:
a first conductive metal layer, provided on a side of the substrate, the first conductive metal layer including a plurality of signal lines;
a first insulating layer, provided on a side of the first conductive metal layer away from the substrate, the first insulating layer being provided with first via holes penetrating the first insulating layer; and
a second conductive metal layer, provided on a side of the first insulating layer away from the substrate, the second conductive metal layer including a plurality of conductive portions and a plurality of transfer lines, wherein a transfer line is connected to a conductive portion and is in electrical contact with a signal line through a first via hole;
wherein the positioning structure is located in any one of the first conductive metal layer, the second conductive metal layer and the first insulating layer.

6. The array substrate according to claim 5, wherein the first insulating layer includes a first insulating sub-layer and a second insulating sub-layer that are provided in a stack, the first insulating sub-layer being closer to the first conductive metal layer relative to the second insulating sub-layer.

7. The array substrate according to claim 5 or 6, further comprising:
a second insulating layer, provided on a side of the second conductive metal layer away from the substrate, the second insulating layer being provided with second via holes penetrating the second insulating layer, wherein a second via hole exposes at least a partial region of the conductive portion;
wherein the positioning structure is located in any one of the first conductive metal layer, the second conductive metal layer, the first insulating layer, and the second insulating layer.

8. The array substrate according to any one of claims 5 to 7, further comprising:
an alignment mark layer, provided between the first conductive metal layer and the substrate, the alignment mark layer including at least one alignment mark;
wherein the positioning structure is located in any one of the first conductive metal layer, the second conductive metal layer, the first insulating layer, and the alignment mark layer; in a case where the array substrate comprises a second insulating layer, the positioning structure is located in any one of the first conductive metal layer, the second conductive metal layer, the first insulating layer, the second insulating layer, and the alignment mark layer.

9. The array substrate according to any one of claims 5 to 8, wherein a side, proximate to the avoidance notch, of the main portion of the positioning structure is exposed by the avoidance notch, and the positioning structure is located in the first insulating layer;
in a case where the array substrate comprises a second insulating layer, the positioning structure is located in the first insulating layer or the second insulating layer.

10. The array substrate according to any one of claims 1 to 9, wherein the array substrate comprises a plurality of positioning structures, the plurality of positioning structures being of a same material and provided in a same layer.

11. An array motherboard, comprising a plurality of array sub-boards, the array sub-boards each including a light-emitting region and a test region, wherein the test region is located on at least one side of the light-emitting region, the test region includes a functional device arrangement region and a peripheral region, and a border between the peripheral region and the functional device arrangement region is a first demarcation line; and
the array sub-board includes:
a substrate motherboard; and
at least one positioning structure, provided on the substrate motherboard and located in the test region, a positioning structure including a main portion, and the main portion being substantially parallel to the first demarcation line, wherein there exists at least such a positioning structure, at least a part of a main portion of the positioning structure is located in the peripheral region, and a boundary, located in the peripheral region, of the main portion of the positioning structure has a maximum distance with the first demarcation line, the maximum distance being greater than a first preset value and less than or equal to a second preset value, wherein the first preset value is a process accuracy at which a portion, located in the functional device arrangement region, of the array sub-board is capable of being removed, and the second preset value is a minimum distance between the light-emitting region and the first demarcation line.

12. The array motherboard according to claim 11, wherein the first demarcation line is in an arc-shape, the positioning structure further includes end portions located at both ends of the main portion, and the end portions of the positioning structure are substantially parallel to a corresponding boundary of the array sub-board.

13. The array motherboard according to claim 12, wherein a positioning structure with a main portion located in the peripheral region is a first positioning structure; a positioning structure with a main portion located in the functional device arrangement region is a second positioning structure; and a positioning structure with a part of a main portion located in the peripheral region and another part of the main portion located in the functional device arrangement region is a third positioning structure, wherein
the main portion of the first positioning structure surrounds the first demarcation line, and the first demarcation line is located between two end portions of the first positioning structure;
the first demarcation line surrounds the main portion of the second positioning structure, and the first demarcation line is located between two end portions of the second positioning structure; and
the main portion of the third positioning structure covers the first demarcation line, and the first demarcation line is located between two end portions of the third positioning structure.

14. The array motherboard according to claim 12 or 13, wherein the array sub-board includes a plurality of positioning structures, wherein
among the plurality of positioning structures, both ends of a positioning structure furthest from a center of the array sub-board extend to a boundary of the array sub-board, and end portions of the positioning structure are substantially flush with the boundary of the array sub-board; and/or same ends of the plurality of positioning structures are connected to form a first line segment, and a line where the first line segment is in intersects with and is substantially perpendicular to a boundary of the peripheral region.

15. The array motherboard according to any one of claims 11 to 14, wherein the array sub-board includes a plurality of positioning structures; and among the plurality of positioning structures, there exists at least such a positioning structure whose main portion has an orthographic projection on a second reference plane substantially overlapping with an orthogonal projection of the first demarcation line on the second reference plane, and the second reference plane is a plane where a surface, away from the positioning structures, of the substrate motherboard is located.

16. The array motherboard according to any one of claims 11 to 15, further comprising:
a first metal film, provided on a side of the substrate motherboard, the first metal film including a plurality of signal lines;
a first insulating film, provided on a side of the first metal film away from the substrate motherboard, the first insulating film being provided with first via holes penetrating the first insulating film;
a second metal film, provided on a side of the first insulating film away from the substrate motherboard, the second metal film including a plurality of conductive portions and a plurality of transfer lines, wherein a transfer line is connected to a conductive portion and is in electrical contact with a signal line through a first via hole; and
a second insulating film, provided on a side of the second metal film away from the substrate motherboard, the second insulating film being provided with second via holes penetrating the second insulating film, wherein a second via hole exposes at least a partial region of the conductive portion;
wherein the positioning structure is located in any one of the first metal film, the second metal film, the first insulating film, and the second insulating film.

17. The array motherboard according to claim 16, wherein a positioning structure with a main portion located in the peripheral region is a first positioning structure; a positioning structure with a main portion located in the functional device arrangement region is a second positioning structure; and a positioning structure with a part of a main portion located in the peripheral region and another part of the main portion located in the functional device arrangement region is a third positioning structure, wherein
the first positioning structure is located in any one of the first metal film, the second metal film, the first insulating film, and the second insulating film; the second positioning structure is located in the first insulating film or the second insulating film; and the third positioning structure is located in the first insulating film or the second insulating film.

18. A light-emitting substrate, comprising:
the array substrate according to any one of claims 1 to 10; and
a plurality of electronic devices, provided on the array substrate.

19. A backlight module, comprising:
the light-emitting substrate according to claim 18, the light-emitting substrate having a light-exit side and a non-light-exit side opposite to each other; and
a plurality of optical film sheets, provided on the light-exit side of the light-emitting substrate.

20. A display apparatus, comprising:
the backlight module according to claim 19;
a functional device, provided at the avoidance notch of the array substrate in the backlight module; and
a display panel, provided on a side, away from the light-emitting substrate, of the plurality of optical film sheets in the backlight module.
